Europäisches Patentamt

European Patent Office

Office européen des brevets

(19)

(11) **EP 1 521 371 A1**

(12) **EUROPÄISCHE PATENTANMELDUNG**

(43) Veröffentlichungstag:
06.04.2005 Patentblatt 2005/14

(51) Int Cl.⁷: **H03M 13/00**, H04L 1/00, H04L 27/26

(21) Anmeldenummer: 04104458.7

(22) Anmeldetag: **15.09.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **30.09.2003 DE 10345435**

(71) Anmelder: **SIEMENS AKTIENGESELLSCHAFT**
**80333 München (DE)**

(72) Erfinder:
• **Bossert, Martin**
  **89075, Ulm (DE)**
• **Costa, Elena**
  **85748, Garching (DE)**
• **Gabidulin, Ernst**
  **141700, Dolgoprudny (RU)**
• **Weckerle, Martin**
  **89134, Blaustein (DE)**
• **Schulz, Egon**
  **80993, München (DE)**

(54) **Verfahren und Kommunikationsvorrichtung zum Dekodieren von mit einem Rang-Code codierten Daten**

(57) Die Erfindung bezieht sich auf ein Verfahren zum Decodieren von Daten-Symbolen ($s_{j,i}$), bei dem die Daten mit einem Rang-Code (**C**), der in Form einer Matrix darstellbar ist, codiert sind, wobei der Rang-Code (**C**) einen Rang mit einer Rang-Distanz (d) kleiner oder gleich dem Rang der Matrix (**C**) aufweist, und die Daten-Symbole mit dem Rang-Code derart in Form einer Matrix (R) mit Zeilen und Spalten als Matrix-Elementen darstellbar moduliert sind, dass Fehler (e) und/oder Auslöschungen (u) in den Matrix-Elementen ($f_j$, $x_i$), sowohl in den Zeilen ($f_j$) als auch in den Spalten ($x_i$) korrigierbar sind. Vorteilhaft wird das Verfahren dadurch, dass eine Zuverlässigkeit der Zeilen ($f_j$) und der Spalten ($x_i$) hinsichtlich Fehlern (e) und/oder Auslöschungen (u) in diesen bestimmt oder geschätzt wird (S1), die Zeile ($f_1$, $f_2$) und/oder Spalte ($x_2$, $x_n$) mit geringer, insbesondere geringster Zuverlässigkeit unter Ausbildung einer Restmatrix (**R**) gelöscht oder entfernt wird (S2) und nachfolgend die Restmatrix (**R**) decodiert wird (S3).

**Beschreibung**

Die Erfindung bezieht sich auf ein Verfahren zum Codieren von Daten, bei dem die Daten mit einem Rang-Code codiert sind, mit den oberbegrifflichen Merkmalen des Patentanspruchs 1 bzw. auf eine Kommunikationsvorrichtung zum Decodieren von mit einer Rang-Matrix codierten Daten mit den oberbegrifflichen Merkmalen des Patentanspruchs 8.

Bei der Verarbeitung von Daten, welche in einem FunkKommunikationssystem über eine Funk-Schnittstelle übertragen werden bzw. übertragen wurden, wird oftmals eine Matrix-Darstellung übertragener Signale mit den Daten verwendet, wie beispielsweise bei Mehr-Träger-Übertragungen gemäß OFDM (Orthogonal Frequency Division Multiplex), Raum-Zeit-Codierung und im Allgemeinen Mehr-Zugriffs-Systemen, wie beispielsweise FDMA (Frequency Division Multiple Access) oder TDMA (Time Division Multiple Access). Bei diesen Verfahren findet eine senderseitige Codierung der Daten zur Übertragung mittels der Sendesignale statt, um empfängerseitig die ggf. durch Störsignale oder Auslöschungen gestörten ursprünglichen Signale rekonstruieren zu können. Bei den bekannten Matrix-Darstellungen werden verschiedene Ansätze verwendet. Beispielsweise stellt jede Spalte ein Codewort eines linearen Codes über einem Feld geringer Dimension dar. Bekannt ist auch, jede Spalte als ein Symbol eines Codes über einem Vergrößerungs- bzw. Extensions-Feld zu verwenden, wie dies von Reed-Solomon-Codes bekannt ist. Außerdem sind sogenannte Rang-Codes bekannt, bei denen jede Matrix durch eine Code-Matrix gebildet wird, wovon nachfolgend ausgegangen wird.

Bei der Übertragung von Sendesignalen mit Daten über eine Vielzahl von Kanälen treten empfängerseitig Burst-Fehler auf. Zur Vermeidung von Burst-Fehlern bzw. zum Ermöglichen einer Korrektur wird eine Verschachtelung (Interleaving) verwendet. Darüberhinaus ist zum Verbessern der Leistungsfähigkeit eines Kommunikationssystems allgemein eine Soft-Decodierung bekannt.

Wenn bei einer empfangenen Daten-Matrix eine geringe Anzahl von Spalten fehlerhaft ist, was am häufigsten auftritt, dann ist die derzeit übliche Lösung zur Fehlervermeidung eine Reed-Solomon-Codierung in Kombination mit Interleaving. Für eine Soft-Decodierung derart codierter Daten sind verschiedene Verfahren bekannt, welche eine gute Leistungsfähigkeit im Fall von Mehrwege-Funk-Kanälen bieten, wie dies beispielsweise aus R. Koetter und A. Vardy, "Soft Decoding of Reed Solomon Codes and Optimal Weight Assignments"; In: Proceed. of ITG Fachtagung, Berlin, Germany, January 2002 [1], bekannt ist. Falls jedoch eine geringe Anzahl von Zeilen der Matrix-Darstellung fehlerhaft ist, was ebenfalls häufig auftritt, dann bieten sich als effektive Alternative Rang-Codes an, welche aus "A New Family of Rank Codes and Applications to Cryptography", Gabidulin, Ourivski, Honary, Ammar, ISIT 2002 (ISIT: IEEE International Symposium on Information Theory), Lausanne [2] und "Theory of Codes with Maximum Rank Distance, Problems of Information Transmission", vol. 21, 1, S.3-16, 1985 [2*] bekannt sind. Die Verwendung von Rang-Codes ermöglicht eine signifikante Reduzierung des erforderlichen Interleaving-Grades, wie dies aus der nachveröffentlichten DE 10300707.5, EP 03000426.1 [3] bekannt ist. Für eine Decodierung bei der Verwendung von Rang-Codes fehlt jedoch ein Verfahren zum Soft-Decodieren der empfangenen Daten.

Verfahren für sowohl eine Hard- als auch eine Soft-Decodierung von Block- und Faltungs-Codes sind in Form verschiedener Algorithmen existent. Um eine Soft-Decodierung durchzuführen, ist aus dem empfangenen Signal eine zusätzliche Information abzuleiten, welche als "Zuverlässigkeit" (Reliability) bezeichnet wird, wie dies aus M. Bossert, Channel Coding for Telecommunications, John Wiley & Sons, Chichester, 1999 [4], insbesondere Seiten 151-153, bekannt ist.

Für die Rang-Codes wurde bislang jedoch nur eine Hard-Decodierung verwendet. Die Hard-Decodierungs-Entscheidung führt für jeden Eintrag der empfangenen Signal-Matrix zu einer Matrix über einem Basisfeld. Eine solche Matrix kann als die Summe einer Code-Matrix und einer Fehler-Matrix dargestellt werden. Bei der Annahme eines Rang-Codes mit einer Rang-Distanz d kann dabei der Rang der Fehler-Matrix kleiner oder gleich der Hälfte der um 1 reduzierten Rang-Distanz d betragen, um eine Korrektur einer entsprechenden Struktur von Fehlern mit Hilfe eines bekannten Rang-Fehler-Korrektur-Algorithmus zu korrigieren, wie dies aus "Space-Time Codes Based on Rank Codes", Bossert, Gabidulin, Lusina, ISIT 2000, Sorrento, Italy [5] bekannt ist.

Die Aufgabe der Erfindung besteht darin, ein verbessertes Verfahren zum Decodieren von mit einem Rang-Code codierten Daten vorzuschlagen.

Diese Aufgabe wird durch ein Verfahren zum Decodieren von mit einem Rang-Code in Form einer Matrix codierten Daten mit den Merkmalen des Patentanspruchs 1 bzw. durch eine Kommunikationsvorrichtung zum Decodieren von mit einer Rang-Matrix codierten Daten mit den Merkmalen des Patentanspruchs 8 gelöst.

Ausgehend von einem Verfahren zum Decodieren von Daten-Symbolen, bei dem die Daten mit einem Rang-Code, der in Form einer Matrix darstellbar ist, codiert sind, wobei der Rang-Code einen Rang mit einer Rang-Distanz kleiner oder gleich dem Rang der Matrix aufweist, und die Daten-Symbole mit dem Rang-Code in Form einer Matrix mit Zeilen und Spalten als Matrix-Elementen darstellbar und derart moduliert sind, dass Fehler e und/oder Auslöschungen u in den Matrix-Elementen, d.h. insbesondere sowohl in den Zeilen als auch in den Spalten zugleich, korrigierbar sind, wird beim bevorzugten Verfahren eine Zuverlässigkeit der Zeilen und der Spalten hinsichtlich Fehlern und/oder Auslöschungen in diesen bestimmt oder geschätzt, zumindest eine der Zeilen und/oder Spalten mit geringer, insbesondere geringster Zuverlässigkeit unter Ausbildung einer Restmatrix gelöscht oder entfernt und nachfolgend die Restmatrix decodiert.

Eine insbesondere zum Durchführen eines solchen Verfahrens ausgebildete Kommunikationsvorrichtung zum Decodieren von mit einem in Form einer Matrix darstellbaren Rang-Code codierten Daten-Symbolen, die in Form einer Matrix mit Zeilen und Spalten als Matrix-Elementen darstellbar sind und die über eine Funk-Schnittstelle übertragen wurden, wobei der Rang-Code einen Rang mit einer Rang-Distanz kleiner oder gleich dem Rang der Matrix aufweist, weist eine Empfangseinrichtung zum Empfangen der codierten Daten-Symbole und eine Decodierungseinrichtung zum Decodieren der empfangenen Daten-Symbole auf. Zusätzlich weist die Kommunikationsvorrichtung eine Zuverlässigkeits-Bestimmungseinrichtung zum Bestimmen der Zuverlässigkeit von Matrix-Elementen der empfangenen Daten-Symbole hinsichtlich Auslöschungen und Fehlern und eine Löschungsund/oder Entfernungseinrichtung zum Löschen oder Entfernen von Matrix-Elementen mit geringer, insbesondere geringster Zuverlässigkeit vor dem Decodieren auf.

Vorteilhafte Ausgestaltungen sind Gegenstand abhängiger Ansprüche.

Vorteilhafterweise wird das Löschen oder Entfernen für eine Anzahl der Zeilen und/oder Spalten bis zu einer Anzahl d - 1 kleiner der Rang-Distanz d durchgeführt wird. Das Löschen wird bevorzugt durch Null-Setzen der Elemente der Zeilen und/oder Spalten durchgeführt, das Entfernen bevorzugt durch eine Dimensionsreduzierung der Zeilen und/oder Spalten oder durch eine Dimensionsreduzierung der Restmatrix mit den codierten Daten durchgeführt.

Vorzugsweise werden bei dem Schritt des Löschens oder Entfernens somit nicht nur eine Zeile und/oder eine Spalte sondern eine größere Anzahl von Zeilen und/oder von Spalten bis zu einer Anzahl kleiner der Rang-Distanz bearbeitet, d. h. gelöscht oder entfernt.

Beim Löschen oder Entfernen sind im Verhältnis zueinander doppelt so viele Zeilen mit Auslöschungen wie Zeilen mit Fehlern korrigierbar. Beim Löschen oder Entfernen von der Anzahl der zu löschenden oder zu entfernenden Zeilen und/oder Spalten mit Auslöschungen u und von der Anzahl des zweifachen der zu löschenden oder der zu entfernenden Zeilen und/oder Spalten mit Fehlern e ist die Summe u + 2e kleiner der Rang-Distanz d, d.h. es gilt u + 2e ≤ d - 1. Das Löschen oder Entfernen der Zeilen und/oder Spalten wird vorzugsweise in Zweier-Schritten durchgeführt.

Bei dem Löschen oder Entfernen von Matrix-Elementen wird somit vorteilhafterweise auch ausgenutzt, dass im Verhältnis zueinander doppelt so viele Auslöschungen wie Fehler korrigierbar sind. Werden nur wenige Matrix-Elemente, also Spalten oder Zeilen mit Fehlern bei zugleich einer großen Rang-Distanz bestimmt, können umso mehr Matrix-Elemente mit Auslöschungen beim Löschen oder Entfernen berücksichtigt werden. Letztendlich wird dabei die Erkenntnis ausgenutzt, dass von der Anzahl der zu löschenden oder zu entfernenden Matrix-Elemente die Summe von einerseits der Anzahl von Matrix-Elementen mit Auslöschungen und andererseits der Anzahl des Zweifachen der Matrix-Elemente mit Fehlern kleiner der Rang-Distanz ist.

Zur Vereinfachung der Algorithmen und unter Ausnutzung der Tatsache, dass Zeilen und Spalten gleichermaßen behandelbar sind, erfolgt das Löschen oder Entfernen der Matrix-Elemente vorteilhafterweise in Zweierschritten. Prinzipiell ist aber auch das Löschen oder Entfernen der Matrix-Elemente in Einerschritten möglich.

Die verfahrenstechnische Umsetzung kann vorteilhafterweise in einer entsprechend ausgebildeten Kommunikationsvorrichtung erfolgen. Die einzelnen Schritte können dabei in eigenständigen Baugruppen oder aber in einer einzigen als integraler Einheit ausgebildeten Baugruppe durchgeführt werden. Insbesondere ist auch die Umsetzung der einzelnen Verfahrensschritte mit Hilfe einer zentralen Steuereinrichtung einer Kommunikationsvorrichtung oder dgl. möglich.

Ein Ausführungsbeispiel der Erfindung mit weiteren hervorzuhebenden vorteilhaften Aspekten und Vorteilen wird nachfolgend anhand der Zeichnung näher erläutert. Es zeigt:

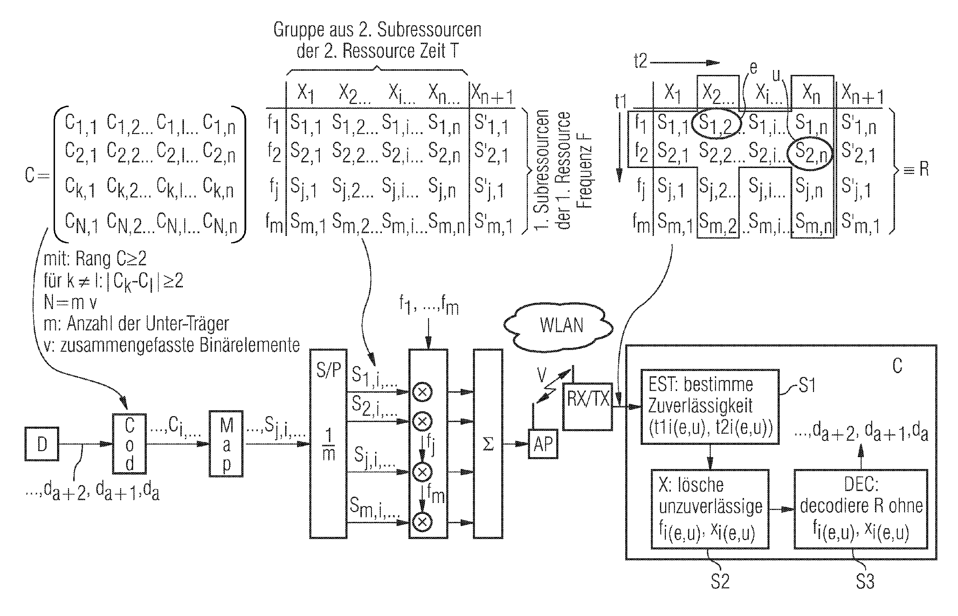

Fig. 1    verschiedene Komponenten einer Sendeeinrichtung und einer Empfangseinrichtung, welche über eine Funkschnittstelle miteinander kommunizieren sowie Codeund Datenelemente, welche verfahrensgemäß verarbeitet werden.

Wie aus Fig. 1 ersichtlich ist, werden von einer Datenquelle D in einer Sendeeinrichtung Daten $d_a$, $d_{a+1}$, $d_{a+2}$, ... bereitgestellt, wobei die Daten nach einer entsprechenden Codierung über eine Funk-Schnittstelle V eines FunkKommunikationssystems WLAN zu einer Empfangseinrichtung übertragen werden. Von der Datenquelle D aus werden die Daten $d_a$, $d_{a+1}$, $d_{a+2}$, ... einer Codierungseinrichtung Cod zugeführt und in dieser mit einem Code **C** in Form einer Matrix mit einzelnen Code-Elementen $c_{k,1}$ mit k = 1, 2, ..., N und 1 = 1, 2, ..., n codiert. Die Matrix **C** weist einen Rang bzw. eine Rang-Distanz d größer 1 auf, wobei für Code-Elemente $c_{k,1}$| **$C_k$** - **$C_1$**| ≥ 2 gilt.

Die Zahl N ergibt sich als Parameter aus dem Produkt der Anzahl der verfügbaren Unterträger sowie der zusammengefassten Binär-Elemente. Berücksichtigt wird dabei, dass jede binäre Code-Matrix als eine binäre Zeichenfolge abgebildet wird, beispielsweise spaltenweise abgebildet wird. Dabei kann angenommen werden, dass eine Konstellation der Größe $q = 2^v$ verwendet wird, wobei z. B. $v = 2$ bei QPSK (Quadratur Phase Shift Keying) gilt. Für eine 16-QAM-Modulation gilt z. B. $q = 16$ und $v = 4$. Die Zeichenfolge wird in sequentielle Stücke der Länge $v$ unterteilt, wobei jedes Stück in das zugeordnete Signal der Konstellation abgebildet wird.

Die derart zu Code-Elementen codierten Daten $c_i$ werden in einer weiteren Verarbeitungseinrichtung Map auf die verfügbaren Ressourcen abgebildet. Bei einem beispielhaften OFDM-Kommunikationssystem werden die Ressourcen aus der Ressource verfügbarer Frequenzen $f$ mit einer Vielzahl von Subressourcen $f_1$, $f_2$, ..., $f_j$, ..., $f_m$ gebildet. Die zweite verfügbare Ressource ist die Zeit $t$, wobei aufeinanderfolgende Zeitschlitze eine Gruppe aus zweiten Subressourcen $x_1$, $x_2$, ..., $x_i$, ..., $x_m$ ausbilden. Es erfolgt somit eine Abbildung der codierten Elemente $c_i$ auf eine Vielzahl von zu übertragenden Daten-Symbolen $s_{j,i}$ mit $j = 1, 2, ..., m$ und $i = 1, 2, ..., n$. Diese Symbolelemente werden einer Seriell-/Parallel-Umsetzungseinrichtung S/P zugeführt, welche eine Umsetzung der seriellen Datenfolge auf eine Anzahl $m$ paralleler Datenleitungen durchführt. Dabei werden jeweils die einem Zeitschlitz $x_i$ zugeordneten Symbole $s_{1,i}$, $s_{2,i}$, ..., $s_{j,i}$, ...$s_{m,i}$ zur weiteren parallelen Verarbeitung auf die $m$ Datenleitungen gesetzt. Die Datenleitungen führen jeweils zu einem Multiplikationsglied zum Durchführen einer Multiplikation mit der entsprechenden Frequenz $f_1$, ..., $f_m$ des zugeordneten Subträgers. Die derart modulierten Daten werden aufsummiert und einem Sendemodul AP zur Übertragung über die Funkschnittstelle V zugeführt.

Empfängerseitig wird das über die Funkschnittstelle V übertragene Signal von einem Empfangsmodul einer Sende- und Empfangseinrichtung RX/TX empfangen und einer Steuereinrichtung C der Empfangseinrichtung zugeführt. Alternativ zur Zuführung zu einer Steuereinrichtung C in Form eines integralen Halbleiterbauelements ist auch die Zuführung zu einzelnen Baugruppen zur Ausführung der verschiedenen Schritte der Datenverarbeitung möglich. Die über die Funkschnittstelle übertragenen Symbole $S_{j,i}$ sind oftmals durch Einflüsse auf der Funkschnittstelle V wie externes Rauschen oder Interferenzen anderer Funksignale gestört. Bei der in Fig. 1 beispielhaft dargestellten empfangenen Folge aus Symbolen $s_{i,j}$ sind bei einer Darstellung als Matrix **R** beispielsweise eine Löschung $u$ eines der empfangenen Symbole $s_{2,n}$ und ein Fehler $e$ eines der Symbole $s_{1,2}$ angenommen. Von der empfangenen Matrix **R** sind somit die erste und die zweite Zeile $f_j$ mit den Subträgern $f_1$, $f_2$, sowie die zweite und die n-te Spalte $x_i$ mit den Zeitschlitzen $x_2$ und $x_n$ gestört.

Die empfangene Matrix **R** mit den empfangenen Symbolen $S_{j,i}$ wird nach einer ggf. erfolgten Vorverarbeitung in einem ersten Decodierungsschritt S1 einer Zuverlässigkeits-Bestimmungseinrichtung EST zugeführt, welche die Zuverlässigkeit der Zeilen $s_j$ und Spalten $x_i$ der empfangenen Matrix **R** hinsichtlich Fehlern $e$ und Auslöschungen $u$ abschätzt oder bestimmt. Als Zuverlässigkeit einer Zeile $s_j$ bzw. Spalte $x_i$ wird dabei bevorzugt die Summe der Zuverlässigkeiten aller Einträge, d. h. aller Symbole $s_{j,i}$ in dieser Zeile bzw. Spalte angenommen.

Dabei oder nachfolgend werden die Zeilen $f_j$ und Spalten $x_i$ mit den geringsten Zuverlässigkeiten ermittelt.

In einem nachfolgenden, zweiten Schritt S2 werden von einer Löschungs- und/oder Entfernungseinrichtung X unzuverlässige Zeilen $f_j(e, u)$ und Spalten $x_i(e, u)$ mit Fehlern $e$ und/oder Auslöschungen $u$ in den Symbolen $s_{1,2}$ bzw. $s_{2,n}$ gelöscht oder entfernt. Das Löschen bzw. Entfernen wird dabei vorzugsweise für bis zu einer Anzahl von Matrix-Elementen, d. h. Zeilen und/oder Spalten der empfangenen Matrix **R** vorgenommen, die kleiner als die Rang-Distanz $d$ ist. Dabei werden die Zeilen und/oder Spalten mit der geringsten Zuverlässigkeit vorzugsweise zuerst gelöscht.

In einem nachfolgenden dritten Schritt S3 erfolgt dann in einer eigentlichen Decodiereinrichtung DEC das Decodieren der empfangenen Matrix **R** ohne die gelöschten bzw. entfernten Matrix-Elemente $f_j(e, u)$ und $x_i(e, u)$. Bei der zu decodierenden empfangenen Matrix **R** handelt es sich somit um eine Rest-Matrix **R** mit einzelnen Zeilen $f_j(e, u)$ und Spalten $x_i(e, u)$, in denen die Werte der einzelnen Matrix-Elemente $s_{j,i}$ auf Null gesetzt sind. Äquivalent dazu ist das Decodieren einer Rest-Matrix **R** mit einer beim Entfernen im zweiten Schritt S2 reduzierten Anzahl von Spalten und/oder Zeilen, d. h. einer Rest-Matrix **R** mit reduzierter Dimension. Nach dem Decodieren werden im Idealfall von der Decodiereinrichtung DEC die ursprünglichen Daten $d_a$, $d_{a+1}$, $d_{a+2}$, ... zur weiteren Verarbeitung ausgegeben.

Vorgeschlagen wird somit ein Verfahren, insbesondere ein Algorithmus mit einer Auslöschung von Matrix-Elementen, d. h. Zeilen und Spalten, um die Implementierung eines vorteilhaften Soft-Decodierungs-Ansatzes für Rang-Codes zu ermöglichen. Unterschieden wird dabei zwischen einerseits Rang-Auslöschungen und andererseits Rang-Fehlern. Ausgegangen wird dabei von einem Codewort in Form der Matrix **C** mit einer Vielzahl von Zeilen und Spalten. Bei der Bestimmung der Zuverlässigkeit wird davon ausgegangen, dass nur eine einzelne Auslöschung auftritt, wenn nur entweder eine Zeile oder eine Spalte ausgelöscht ist. Entsprechend tritt eine Anzahl $u$ Auslöschungen auf, falls $t1$ der Zeilen $f_j$ ausgelöscht sind und $t2$ der Spalten $x_i$ ausgelöscht sind, wobei sich die Anzahl $u$ ausgelöschter Matrix-Elemente $f_j$, $x_i$ als Summe $u = t1 + t2$ ergibt. Der Unterschied zwischen Auslöschungen und Fehlern der empfangenen Symbole $s_{j,1}$ besteht darin, dass die Positionen der Auslöschungen bekannt sind. Bei Fehlern in den empfangenen Symbolen $s_{j,1}$ sind hingegen sowohl der eigentliche Fehler bzw. Fehlerwert als auch die Position des Fehlers innerhalb der empfangenen Matrix **R** unbekannt. Allgemein kann daher davon ausgegangen werden, dass die empfangene Matrix **R** zu decodieren ist, welche $u$ Auslöschungen und $e$ Fehler aufweist, wobei die maximale Anzahl von korrigierbaren Auslöschungen und Fehlern, d. h. die maximale Anzahl von im zweiten Schritt S2 löschbaren bzw. entfernbaren Matrix-Elementen, bestimmt wird durch $u + 2e \leq d - 1$. D. h., die Summe der auslöschbaren bzw. entfernbaren Matrix-Elemente mit Auslöschungen in den empfangenen Matrix-Elementen einerseits und andererseits aus dem Zweifachen der fehlerbehafteten Symbole bzw. Matrix-Elemente ist kleiner als die Rang-Distanz d.

Durch die Entfernung bzw. Auslöschung der unzuverlässigsten Matrix-Elemente wird eine reduzierte Rest-Matrix **R** erhalten, die beispielsweise mit einem für sich bekannten Rang-Fehler-Korrektur-Algorithmus decodierbar ist. Da der entsprechende Algorithmus Fehler in allen Zeilen und Spalten korrigiert, handelt es sich um ein vorteilhaftes Verfahren. Die Korrektur von Auslöschungen u in Spalten $x_i$ ist relativ einfach. Um bis zu einer Anzahl d - 1 von Spalten kleiner der Rang-Distanz d an Spaltenauslöschungen zu korrigieren, werden aus der empfangenen Matrix die am wenigsten zuverlässigen Spalten $x_i$ ausgelöscht bzw. entfernt. Nachfolgend wird ein schneller Matrix-Decodier-Algorithmus auf den dimensionsgekürzten empfangenen Vektor angewendet, um die korrekte Informationsabfolge bzw. die ursprünglichen korrigierten Daten zu erhalten.

Zur Beschreibung der Korrektur von Zeilenauslöschungen wird beispielhaft angenommen, dass die j-te Zeile $f_j$ ausgelöscht ist. Dann kann ein Fehler **e** in der Form **e** = $[e_{1,j}\alpha^j, e_{2,j}\alpha^j, ..., e_{n,j}\alpha^j]$ beschrieben werden. Dabei ist der Laufindex j bekannt, die binären Werte $e_{i,j}$, i = 1, 2, ..., n sind jedoch unbekannt. Aus der empfangenen Matrix **R** kann ein binäres lineares System aus (d - 1)n Gleichungen mit n binären Unbekannten aufgebaut werden. Dies ermöglicht den Vektor der Fehler **e** zurückzugewinnen. Die Korrektur von Spaltenauslöschungen und die Korrektur von Zeilenauslöschungen als solches bei dem Schritt des Decodierens S3 kann in bekannter Art und Weise [5] ausgeführt werden.

Die Korrektur eines einzelnen Fehlers kann in der nachfolgenden, allgemein beschriebenen Art und Weise durchgeführt werden. Ein einzelner Rang-Fehler **e** ist beschreibbar in der Form

$$e = \begin{bmatrix} e_1\beta & e_2\beta & ... & e_n\beta \end{bmatrix}.$$

wobei $\beta$ ein unbekanntes Element des Galois-Feldes $GF(2^n)$ ist und einzelne Fehlerelemente $e_1, e_2, ..., e_n$ unbekannte binäre Koeffizienten sind. Damit lässt sich das Syndrom **s** berechnen durch:

$$s = eH^t = [s_0, s_1];$$

$$s_0 = \beta\sum\nolimits_{i=1}^{n} e_i h_i;$$

$$s_1 = \beta\sum\nolimits_{i=1}^{n} e_i h_i^2.$$

Unter Berücksichtigung, dass

$$s_0^2 = \beta^2\sum_{i=1}^{n} e_i h_i^2 = \beta s_1$$

gilt, folgt für die einfachen Umsetzungen hinsichtlich

$$\sum\nolimits_{i=1}^{n} e_i h_i^2$$

für die unbekannte Größe

$$\beta = \frac{s_0^2}{s_1}.$$

Dabei ist $s_0/\beta = s_1/s_0$ beschreibbar als binäre Spalte

$$s_0 / \beta = s_1 / s_0 = \begin{bmatrix} a_0 \\ a_1 \\ \vdots \\ a_{n-1} \end{bmatrix}.$$

Weiterhin ist jedes $h_i$ als binäre Spalte darstellbar:

$$h_i = \begin{bmatrix} b_{0,i} \\ b_{1,i} \\ \vdots \\ b_{n-1,i} \end{bmatrix}$$

Letztendlich ist damit ein System aus linearen Gleichungen

$$\begin{bmatrix} a_0 = e_1 b_{0,1} + e_2 b_{0,2} + \cdots + e_n b_{0,n} \\ a_1 = e_1 b_{1,1} + e_2 b_{1,2} + \cdots + e_n b_{1,n} \\ \vdots \\ a_n = e_1 b_{n,1} + e_2 b_{n,2} + \cdots + e_n b_{n,n} \end{bmatrix}$$

erzielbar. Dieses System weist die eindeutige Lösung für die unbekannten Fehlerelemente $e_i$ auf, da $h_1$, $h_2$, ..., $h_n$ linear abhängig sind und folglich die quadratische Matrix des Systems der Koeffizienten $[b_{i,j}]$ nicht singulär ist.
Für die Korrektur doppelter Zeilenauslöschungen wird vorgegangen wie folgt, wobei angenommen wird, dass die i-te und die j-te Spalte korrumpiert sind, Fehler in diesen Spalten jedoch unbekannt sind. Diese Spalten mit Fehlern können bezeichnet werden durch $\gamma_i$ und $\gamma_j$. Die Berechnung des Syndroms ergibt ein System aus zwei Gleichungen

$$\gamma_i \, h_i + \gamma_j h_j = s_0$$

$$\gamma_i h_i^2 + \gamma_j h_j^2 = s_1,$$

Daher gilt mit einfachen Umstellungen

$$\gamma_i = \frac{s_0 h_j + s_1}{h_i(h_i + h_j)},$$

$$\gamma_j = \frac{s_0 h_i + s_1}{h_j(h_i + h_j)},$$

wobei die Berechnungen in dem Galois-Feld GS($2^n$) durchgeführt werden.

Die Korrektur von doppelten Zeilenauslöschungen kann durchgeführt werden, wie folgt, wobei angenommen wird, dass Auslöschungen in der i-ten und in der j-ten Zeile vorliegen. Dies bedeutet, dass ein Vektor aus Fehlern **e** beschreibbar ist in der Form

$$e = [e_{i,1}\alpha^i + e_{j,1}\alpha^j, e_{i,2}\alpha^i + e_{j,2}\alpha^j, \ldots, e_{i,n}\alpha^i + e_{j,n}\alpha^j]$$

mit unbekannten Fehlerelementen $e_{i,1}$, $e_{i,2}$, ..., $e_{i,n}$ und $e_{j,1}$, $e_{j,2}$, ..., $e_{j,n}$. Die Berechnung des Syndroms führt zu

$$\alpha^i \sum_{s=1}^{n} e_{i,s} h_s + \alpha^j \sum_{s=1}^{n} e_{j,s} h_s = s_O,$$

$$\alpha^i \sum_{s=1}^{n} e_{i,s} h_s^2 + \alpha^j \sum_{s=1}^{n} e_{j,s} h_a^2 = s_1.$$

Dabei können Variablen X, Y eingeführt werden mit

$$X = \sum_{s=1}^{n} e_{i,s} h_s, \quad Y = \sum_{s=1}^{n} e_{j,s} h_s.$$

Die Exponentierung der zweiten Gleichung mit dem Exponenten $2^{n-1}$ führt zu einem linearen System

$$\alpha^i X + \alpha^j Y = s_0,$$

$$a^{2^{n-1}i} X + \alpha^{2^{n-1}j} Y = s_1^{2^{n-1}}$$

oder

$$X = \sum_{s=1}^{n} e_{i,s} h_s = \frac{\alpha^{2^{n-1}j} s_0 + \alpha^i s_1^{2^{n-1}}}{\alpha^i \alpha^{2^{n-1}j} + \alpha^j \alpha^{2^{n-1}i}},$$

$$Y = \sum_{s=1}^{n} e_{j,s} h_s = \frac{\alpha^{2^{n-1}i} s_0 + \alpha^j s_1^{2^{n-1}}}{a^i a^{2^{n-1}j} + a^j a^{2^{n-1}i}}.$$

Nachfolgend werden diese beiden linearen Systeme in einer Art und Weise ähnlich der vorstehend beschriebenen gelöst, um die unbekannten Fehlerelemente $e_{i,s}$, $e_{j,s}$, s = 1, 2, ..., n zu erhalten.

Zur Korrektur von Zeilen- und Spaltenauslöschungen wird nachfolgend angenommen, dass Auslöschungen in der i-ten Zeile und der j-ten Spalte vorliegen. Unter dieser Annahme ist ein Vektor des Fehlers **e** beschreibbar in der Form

$$e = e_1 + e_2,$$

$$e = [0,0,...\gamma_j,0,....0],$$

$$e_2 = [e_{i,1}\alpha^i, e_{i,2}\alpha^i,...,e_{i,n}\alpha^i]$$

mit unbekannten $e_{i,s}$, $\gamma_j$. Die Berechnung der Syndrome ergibt

$$\gamma_j h_j + \alpha^i \sum_{s=1}^{n} e_{i,s} h_s = s_0,$$

$$\gamma_j h_j^2 + \alpha^i \sum_{s=1}^{n} e_{i,s} h_s^2 = s_1.$$

Das Erhöhen der ersten Gleichung zur zweiten Potenz, Multiplizieren der zweiten Gleichung mit $\alpha^i$ und eine Subtraktion führt für $\gamma_j$ zu der Gleichung:

$$\gamma_j^2 h_j^2 + \gamma_j h_j^2 \alpha^j = s_0^s + s_1 \alpha^i.$$

Dies ermöglicht, $\gamma_j$ zu erzielen. Damit können aus der ersten Gleichung die Fehlerwerte $e_{i,s}$ in der vorstehend beschriebenen Art und Weise bestimmt werden.

Beschrieben wird somit ein vorteilhaftes Verfahren zum Vorverarbeiten empfangener Daten vor der eigentlichen Decodierung, wobei die Daten mit Rang-Codes codiert sind. Eine Anwendung bietet sich insbesondere im Bereich von Mehr-Trägerbasierten kabellosen und mobilen Kommunikationssystemen, beispielsweise OFDM an. Neben dem Einsatz in bekannten Funk-Kommunikationssystemen bietet sich auch der Einsatz in neuen Kommunikationssystemen mit einer Funk-Schnittstelle der dritten Generation und zukünftiger Generationen an.

**Patentansprüche**

1.  Verfahren zum Decodieren von Daten-Symbolen ($s_{j,i}$), bei dem

    -   die Daten mit einem Rang-Code ($c_{1,k}$), der in Form einer Matrix (**c**) darstellbar ist, codiert sind, wobei der Rang-Code ($c_{1,k}$) einen Rang mit einer Rang-Distanz (d) kleiner oder gleich dem Rang der Matrix (**C**) aufweist, und
    -   die Daten-Symbole mit dem Rang-Code in Form einer Matrix (**R**) mit Zeilen ($f_j$) und Spalten ($x_i$) als Matrix-Elementen ($f_j$, $x_i$) darstellbar und derart moduliert sind, dass Fehler (e) und/oder Auslöschungen (u) in den Matrix-Elementen ($f_j$, $x_i$), sowohl in den Zeilen ($f_j$) als auch in den Spalten ($x_i$), korrigierbar sind,

    **dadurch gekennzeichnet, dass**

    -   eine Zuverlässigkeit der Zeilen ($f_j$) und der Spalten ($x_i$) hinsichtlich Fehlern (e) und/oder Auslöschungen (u) in diesen bestimmt oder geschätzt wird (S1),
    -   eine der Zeilen ($f_1$, $f_2$) und/oder Spalten ($x_2$, $x_n$) mit geringer Zuverlässigkeit unter Ausbildung einer Restmatrix gelöscht oder entfernt wird (S2) und
    -   nachfolgend die Restmatrix decodiert wird (S3).

2.  Verfahren nach Anspruch 1, bei dem das Löschen oder Entfernen (S2) für eine Anzahl der Zeilen und/oder Spalten bis zu einer Anzahl (d - 1) kleiner der Rang-Distanz (d) durchgeführt wird.

3.  Verfahren nach Anspruch 1 oder 2, bei dem das Löschen (S2) durch Null-Setzen der Elemente der Zeilen und/oder Spalten durchgeführt wird.

4.  Verfahren nach Anspruch 1 oder 2, bei dem das Entfernen (S2) durch eine Dimensionsreduzierung der Zeilen und/oder Spalten oder durch eine Dimensionsreduzierung der Restmatrix (**R**) mit den codierten Daten ($S_{j,i}$) durchgeführt wird.

5. Verfahren nach einem vorstehenden Anspruch, bei dem beim Löschen oder Entfernen im Verhältnis zueinander doppelt so viele Zeilen mit Auslöschungen (u) wie Zeilen mit Fehlern (e) korrigierbar sind.

6. Verfahren nach einem vorstehenden Anspruch, bei dem beim Löschen oder Entfernen (S2) von der Anzahl der zu löschenden oder zu entfernenden Zeilen ($f_2$) und/oder Spalten ($x_n$) mit Auslöschungen (u) und von der Anzahl des zweifachen der zu löschenden oder der zu entfernenden Zeilen ($f_2$) und/oder Spalten ($x_2$) mit Fehlern (e) die Summe (u + 2e) kleiner der Rang-Distanz (d) ist (u + 2e $\leq$ d - 1).

7. Verfahren nach einem vorstehenden Anspruch, bei dem das Löschen oder Entfernen (S2) der Zeilen ($f_2$) und/oder Spalten ($x_2$) in Zweier-Schritten durchgeführt wird.

8. Kommunikationsvorrichtung zum Decodieren von mit einem in Form einer Matrix (**C**) darstellbaren Rang-Code ($\mathbf{c}_{1,k}$) codierten Daten-Symbolen ($s_{j,i}$), die in Form einer Matrix mit Zeilen ($f_j$) und Spalten ($x_i$) als Matrix-Elementen darstellbar sind und die über eine Funk-Schnittstelle (V) übertragen wurden, wobei der Rang-Code einen Rang mit einer Rang-Distanz (d) kleiner oder gleich dem Rang der Matrix (C) aufweist, mit

- einer Empfangseinrichtung (RX/TX) zum Empfangen der codierten Daten-Symbole ($S_{j,i}$) und
- einer Decodierungseinrichtung (DEC) zum Decodieren der empfangenen Daten-Symbole,

**gekennzeichnet durch**

- eine Zuverlässigkeits-Bestimmungseinrichtung (EST) zum Bestimmen der Zuverlässigkeit von Matrix-Elementen der empfangenen Daten-Symbole hinsichtlich Auslöschungen (u) und Fehlern (e) und
- einer Löschungs- und/oder Entfernungseinrichtung (X) zum Löschen oder Entfernen von Matrix-Elementen mit geringer Zuverlässigkeit vor dem Decodieren.

**Europäisches Patentamt**

# EUROPÄISCHER RECHERCHENBERICHT

Nummer der Anmeldung

EP 04 10 4458

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | S. PLASS: "Rank-Codes for OFDM" August 2003 (2003-08), TELECOMMUNICATIONS AND APPLIED INFORMATION THEORY, UNIVERSITY OF ULM , ULM , XP002305068 * Seite 1 - Seite 78 * * Absatz [4.4.3.1] * ----- | 1-8 | H03M13/00 H04L1/00 H04L27/26 |
| X | GABIDULIN E M ET AL: "A new method of erasure correction by rank codes" ISIT 2003, 29. Juni 2003 (2003-06-29), Seiten 423-423, XP010657451 YOKOHAMA, JAPAN * Seite 423 * ----- | 1-8 | |
| D,A | R. KOETTER UND A. VARDY: "Soft Decoding of Reed Solomon Codes and OPtimal Weight Assignments" ITG-FACHBERICHT 170 4TH INTERNATIONAL ITG CONFERENCE ON SOURCE AND CHANNEL CODING, Januar 2002 (2002-01), Seiten 69-74, XP002305066 BERLIN * Seite 69 - Seite 74 * ----- | 1,8 | |
| D,A | E.M. GABIDULIN: "Theory of Codes with Maximum Rank Distance" PROBLEMS OF INFORMATION TRANSMISSION, Bd. 21, Nr. 1, Juli 1985 (1985-07), Seiten 1-12, XP002305067 NEW YORK * Seite 1 - Seite 12 * ----- | 1,8 | **RECHERCHIERTE SACHGEBIETE (Int.Cl.7)** H03M H04L |
| P,A, D | EP 1 437 850 A (SIEMENS AG) 14. Juli 2004 (2004-07-14) * Seite 2, Zeile 1 - Seite 6, letzte Zeile * ----- -/-- | 1,8 | |

Der vorliegende Recherchenbericht wurde für alle Patentansprüche erstellt

| Recherchenort | Abschlußdatum der Recherche | Prüfer |
|---|---|---|
| Den Haag | 11. November 2004 | Van Staveren, M |

EPO FORM 1503 03.82 (P04C03)

**Europäisches Patentamt**

**EUROPÄISCHER RECHERCHENBERICHT**

Nummer der Anmeldung

EP 04 10 4458

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | GABIDULIN E ET AL: "A new family of rank codes and applications to cryptography" PROCEEDINGS 2002 IEEE INTERNATIONAL SYMPOSIUM ON INFORMATION THEORY. ISIT 02. LAUSANNE, SWITZERLAND, JUNE 30 - JULY 5, 2002, IEEE INTERNATIONAL SYMPOSIUM ON INFORMATION THEORY, NEW YORK, NY : IEEE, US, 30. Juni 2002 (2002-06-30), Seiten 268-268, XP010601979 ISBN: 0-7803-7501-7 * Seite 268 - Seite 268 * ----- | 1,8 | |
| D,A | GABIDULIN E M ET AL: "Space-time codes based on rank codes" INTERNATIONAL SYMPOSIUM ON INFORMATION THEORY, ISIT 2000, 25. Juni 2000 (2000-06-25), Seiten 284-284, XP010510160 SORRENTO, ITALY * Seite 284 - Seite 284 * ----- | 1,8 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| Den Haag | 11. November 2004 | Van Staveren, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 10 4458

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-11-2004

| Im Recherchenbericht angeführtes Patentdokument | Datum der Veröffentlichung | Mitglied(er) der Patentfamilie | Datum der Veröffentlichung |
|---|---|---|---|
| EP 1437850 A | 14-07-2004 | EP 1437850 A1 | 14-07-2004 |
| | | WO 2004064282 A2 | 29-07-2004 |